# EUROPEAN PATENT APPLICATION

(11) **EP 4 788 098 A1**
(43) Date of publication of application: **05.08.2026**
(21) Application number: 24890454.2
(22) Date of filing: 23.10.2024
(51) Int. Cl.: H10H 20/00, H01L 21/3065

(54) **METHOD FOR MANUFACTURING SEMICONDUCTOR DEVICE, AND SEMICONDUCTOR PROCESS APPARATUS**

(30) Priority: 17.11.2023 CN 202311542265
(71) Applicant: Beijing NAURA Microelectronics Equipment Co., Ltd., Beijing 100176 (CN)
(72) Inventor: CHEN, Yongfeng, Beijing 100176 (CN)
(74) Representative: Cohausz & Florack
(86) International application number: PCT/CN2024/126619
(87) International publication number: WO 2025/103097

(57) **Abstract**

The present application discloses a method for manufacturing a semiconductor device and a semiconductor process apparatus. The method includes: modifying a roughened layer with a first process gas to reduce surface roughness of the roughened layer, the first process gas including a chemical etching gas capable of reacting with the roughened layer and a physical bombardment gas capable of physically bombarding the roughened layer, and a proportion of the physical bombardment gas in the first process gas being greater than a proportion of the chemical etching gas in the first process gas; and etching the modified roughened layer, a second-conductivity-type semiconductor layer, an active layer, and a first-conductivity-type semiconductor layer to a target depth with a second process gas. The present disclosure can reduce a loading influence of etching by-products of a roughened surface on etching, and improve brightness and electrical stability of chips.

## Description

### TECHNICAL FIELD

The present disclosure relates to the field of semiconductor technology, and in particular, to a method for manufacturing a semiconductor device, and a semiconductor process apparatus.

### BACKGROUND

At present, in order to prepare a high-brightness LED chip, a scheme of directly increasing current is generally adopted in the industry to increase brightness; however, for the chip, as a load current increases, the LED chip may overheat and age, which affects a service life thereof. With technical development and improvement, a process flow needs to be optimized based on the improvement scheme of the high-brightness LED. In this regard, performing a roughening process on the chip is adopted in mainstream manufacturing processes. On the one hand, the roughened surface increases the probability of photon extraction; On the other hand, light having an incident angle greater than the critical angle can, through multiple refractions, be redirected such that the incident angle becomes smaller than the critical angle, thereby improving the brightness performance of the device. For a red-yellow (light color) AlGaInP (aluminum gallium indium phosphide) roughening process, a roughening process step is performed before an etching process step, which can not only reduce the number of process steps, but also ensure sidewall morphology while improving brightness, reduce sidewall damage, and improve electrical stability of the device. However, when the roughening process step is adopted, during the etching which is performed after the roughening, area of a roughened surface of a top is increased, the top is loose and porous, and an etched sidewall is rough, which severely affects electrical performance and light-emitting effect of the device. Secondly, for the red-yellow etching process, by-products corresponding to In and Al which have high volatilization temperatures are hard to volatilize; in particular, with an increase in loading, desorption of the by-products from a sample surface becomes harder, such that mask-like substances are generated and "black spots" (bumps) are gradually formed on the etched sidewall and bottom as the etching proceeds, resulting in a risk of electrical leakage during device packaging. Thus, how to implement an etching process for red-yellow AlGaInP with a roughened surface is the key for improving performance of the LED chip.

### SUMMARY

The present disclosure aims to provide a method for manufacturing a semiconductor device, and a semiconductor process apparatus, which can reduce a loading influence of etching by-products of a roughened surface on etching and improve brightness and electrical stability of chips.

In order to achieve the above objective, in a first aspect, the present disclosure provides a method for manufacturing a semiconductor device, the semiconductor device including a first-conductivity-type semiconductor layer, an active layer, and a second-conductivity-type semiconductor layer which are stacked from bottom to top, a roughened layer being disposed on a surface of the second-conductivity-type semiconductor layer, and the method including:
modifying the roughened layer with a first process gas to reduce surface roughness of the roughened layer, the first process gas including a chemical etching gas capable of reacting with the roughened layer and a physical bombardment gas capable of physically bombarding the roughened layer, and a proportion of the physical bombardment gas in the first process gas being greater than a proportion of the chemical etching gas in the first process gas; and
etching the modified roughened layer, the second-conductivity-type semiconductor layer, the active layer, and the first-conductivity-type semiconductor layer to a target depth with a second process gas.

In some embodiments, the roughened layer contains In and/or Al.

In some embodiments, a material of the roughened layer includes AlGaInP.

In some embodiments, a gas flow ratio range of the physical bombardment gas to the chemical etching gas in the first process gas is 5:1 to 20:1; or
a flow range of the physical bombardment gas is 25 sccm to 200 sccm, and a flow range of the chemical etching gas is 5 sccm to 40 sccm; or
a total gas flow range of the physical bombardment gas and the chemical etching gas in the first process gas is 30 sccm to 240 sccm; or
at step of etching the roughened layer with the first process gas, a pressure range of a process chamber is 2 mT to 8 mT.

In some embodiments, process parameters adopted at step of etching the roughened layer with the first process gas further include:
an upper electrode radio frequency power range: 300 W to 800 W;
a lower electrode radio frequency power range: 50 W to 300 W;
a process temperature range: 120°C to 150°C; and
a process time range: 10 s to 60 s.

In some embodiments, the chemical etching gas includes Cl₂, and the physical bombardment gas includes Ar.

In some embodiments, the roughened layer, the first-conductivity-type semiconductor layer, and the second-conductivity-type semiconductor layer are made of the same material.

In some embodiments, the second process gas includes Cl₂, BCl₃, and HBr.

In some embodiments, a gas flow ratio range of Cl₂, BCl₃, and HBr in the second process gas is 1:2:5 to 1:2:20; or
in the second process gas, a flow range of Cl₂ is 5 sccm to 20 sccm, a flow range of BCl₃ is 20 sccm to 40 sccm, and a flow range of HBr is 25 sccm to 100 sccm; or
a chamber pressure range is 2 mT to 6 mT; or
at step of continuously etching the roughened layer, the second-conductivity-type semiconductor layer, the active layer, and the first-conductivity-type semiconductor layer to the target depth with the second process gas, an upper electrode radio frequency power range is 400 W to 900 W, and a lower electrode radio frequency power range is 200 W to 450 W.

In a second aspect, the present disclosure provides a semiconductor process apparatus, including a process chamber, a gas inlet assembly, an upper electrode assembly, a lower electrode assembly, and a controller, and the controller includes at least one processor and at least one storage device having stored therein a computer program which, when executed by the at least one processor, implements the method for manufacturing a semiconductor device described in the first aspect.

The present disclosure can produce the following beneficial effects:
with the etching method provided in the present disclosure, the roughened layer is first modified with the first process gas including the chemical etching gas and the physical bombardment gas, that is, the surface roughness of the roughened layer is reduced under a chemical etching effect of the chemical etching gas and a physical bombardment effect of the physical bombardment gas. By setting the proportion of the physical bombardment gas in the first process gas to be greater than that of the chemical etching gas in the first process gas, on the one hand, ion bombardment is performed on a roughened surface of the roughened layer by use of physical bombardment characteristics of ions of the physical bombardment gas, thereby reducing the surface roughness; on the other hand, by simultaneously using a smaller amount of chemical etching gas, a bombardment effect can be adjusted, and chemical etching can be additionally performed on the roughened surface, thereby further reducing the surface roughness of the roughened layer, and achieving etching on debris generated by ion bombardment to reduce subsequent generation of protrusions on the etched surface. Thus, a loading influence caused by etching by-products of the roughened surface can be reduced, and the subsequent generation of the protrusions on the etching surface can also be reduced. In the subsequent process of continuously etching to the target depth with the second process gas, since an etching load of the surface of the roughened layer is reduced by the modification, smooth etching morphology can be obtained, which improves brightness and electrical stability of chips.

The system of the present disclosure has other features and advantages, which will become apparent from the accompanying drawings and the following detailed description or will be described in detail with reference to the accompanying drawings and the following detailed description. The drawings together with the detailed description are used to explain a certain principle of the present disclosure.

### BRIEF DESCRIPTION OF DRAWINGS

The above and other objectives, features and advantages of the present disclosure will become more apparent from the description of exemplary embodiments of the present disclosure with reference to the accompanying drawings. In the exemplary embodiments of the present disclosure, the same reference numeral generally denotes the same element.
FIG. 1 is a schematic diagram of a semiconductor device corresponding to each step of a conventional etching process for a red-yellow AlGaInP roughened surface.
FIG. 2 is an electron microscope image illustrating an etching result of an etching method for an AlGaInP roughened surface in a first related technique.
FIG. 3 is an electron microscope image illustrating an etching result of an etching method for an AlGaInP roughened surface in a second related technique.
FIG. 4 is a flowchart illustrating a method for manufacturing a semiconductor device according to an embodiment of the present disclosure.
FIG. 5a to FIG. 5c are schematic diagrams of a semiconductor device corresponding to each step in a method for manufacturing a semiconductor device according to an embodiment of the present disclosure.
FIG. 6 is an electron microscope image illustrating an etching result of a method for manufacturing a semiconductor device according to an embodiment of the present disclosure.
FIG. 7 is a schematic diagram of a semiconductor process apparatus according to an embodiment of the present disclosure.

### DETAIL DESCRIPTION OF EMBODIMENTS

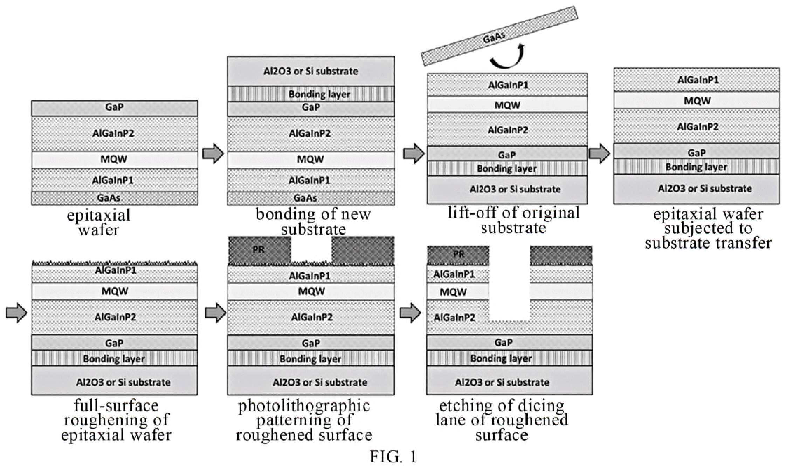

A conventional red-yellow AlGaInP roughening-etching process flow is as shown in FIG. 1. Firstly, an AlGaInP epitaxial wafer is provided, and the AlGaInP epitaxial wafer includes a GaAs layer, a first AlGaInP layer (AlGaInP1), a multiple quantum well layer (MQW), a second AlGaInP layer (AlGaInP2), and a GaP layer which are stacked. Then, bonding of a new substrate is performed; exemplarily, a sapphire substrate (Al₂O₃) or a silicon substrate (Si substrate) is bonded to the GaP layer through a bonding layer (Bonding layer). Then, lift-off of the original substrate is performed to remove the GaAs layer, a full-surface roughening process is then performed on a surface of the first AlGaInP layer of the epitaxial wafer, a photoresist layer (PR) is then formed on the roughened surface and subjected to photolithographic patterning (a patterning process), and the film layers corresponding to a dicing lane region exposed by the photoresist are then etched to a target depth by one-step etching.

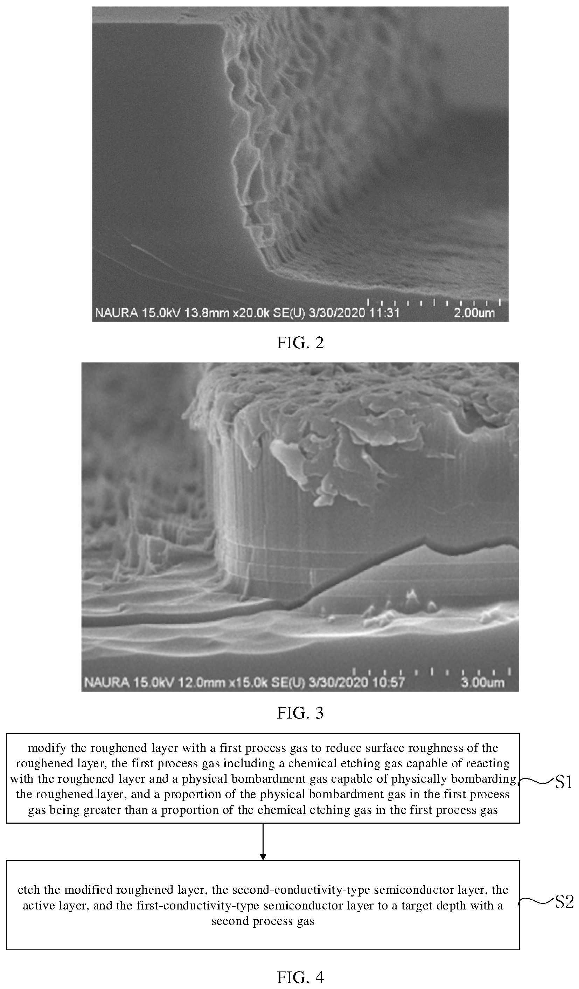

In a first related technique, a BCl₃+Cl₂ etching gas system is adopted for AlGaInP etching. One-step etching is generally adopted for etching of red-yellow AlGaInP; since by-products are hard to volatilize, surface morphology may be severely affected if there is a pause during the etching. A typical AlGaInP etching recipe is as follows: 1.5 mT-5 mT/SRF 400-1500/BRF 50-500/10-150 Cl₂+5-50 BCl₃/4 T-8T backside He/20°C-80°C chiller. Specifically, a chamber pressure range is 1.5 mT to 5 mT; an upper electrode radio frequency (SRF) power range is 400 W to 1500 W; a lower electrode RF(BRF) power range is 50 W to 500 W; a gas flow range of Cl₂ is 10 sccm to 150 sccm; a gas flow range of BCl₃ is 5 sccm to 50 sccm; a pressure of a backside gas (He) ranges from 4 Torr to 8 Torr; and a temperature range of a chiller is 20°C to 80°C. The sidewall and bottom are rough after being etched according to this recipe, as shown in FIG. 2.

In a second related technique, a Cl₂+BCl₃+Hbr gas system is generally adopted for one-step AlGaInP etching. One-step etching is also adopted for etching of red-yellow AlGaInP; since by-products are hard to volatilize, surface morphology may be severely affected if there is a pause during the etching. A typical AlGaInP etching recipe is as follows: 1.5 mT-5 mT/SRF 300-1000/BRF 150-500/5-50 Cl₂+5-50 BCl₃+5-100 HBr/4 T-8T backside He/0-80°C chiller. Specifically, a chamber pressure range is 1.5 mT to 5 mT; an upper electrode RF power range is 300 W to 1000 W; a lower electrode RF power range is 150 W to 500 W; a gas flow range of Cl₂ is 5 sccm to 50 sccm; a gas flow range of BCl₃ is 5 sccm to 50 sccm; a gas flow range of HBr is 5 sccm to 100 sccm; a pressure of a backside gas (He) ranges from 4 Torr to 8 Torr; and a temperature range of a temperature control system (i.e., a chiller) is 0°C to 80°C. After the etching is performed according to this recipe, bottom morphology exhibits abnormal protrusions with high density, a top is partially damaged, etching morphology cannot be ensured, and an etching result is as shown in FIG. 3.

The present disclosure provides a method for manufacturing a semiconductor device, and a semiconductor process apparatus, which can reduce a loading influence of surface roughness of a roughened layer, and improve brightness and electrical stability of chips.

The present disclosure will be described in detail below with reference to the drawings. Although the drawings illustrate the preferable embodiments of the present disclosure, it should be understood that the present disclosure can be implemented in various forms and should not be limited to the embodiments described herein. On the contrary, the embodiments are provided to make the present disclosure more thorough and complete and fully convey the scope of the present disclosure to those of ordinary skill in the art.

### First Embodiment

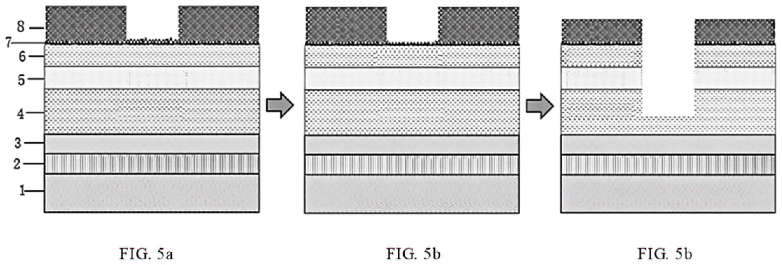

As shown in FIG. 4 and FIG. 5a, the present embodiment provides a method for manufacturing a semiconductor device, the semiconductor device includes a first-conductivity-type semiconductor layer 4, an active layer 5, and a second-conductivity-type semiconductor layer 6 which are stacked from bottom to top, and a roughened layer 7 is disposed on a surface of the second-conductivity-type semiconductor layer 6. It should be noted that "from bottom to top" refers to a direction moving away from a substrate layer 1.

The method includes the following steps.

At S1, the roughened layer 7 is modified with a first process gas, so as to reduce surface roughness of the roughened layer 7. The first process gas includes a chemical etching gas capable of reacting with the roughened layer 7, and a physical bombardment gas capable of physically bombarding the roughened layer 7, and a proportion of the physical bombardment gas in the first process gas is greater than that of the chemical etching gas in the first process gas.

In some embodiments, the roughened layer 7 contains In and/or Al. In the present embodiment, a material of the roughened layer 7 includes AlGaInP, and the roughened layer 7, the first-conductivity-type semiconductor layer 4, and the second-conductivity-type semiconductor layer 6 are made of the same material; and the active layer 5 is a multiple quantum well layer.

As shown in FIG. 5a, the semiconductor device in the present embodiment includes, from bottom to top, the substrate layer 1, a bonding layer 2, a GaP layer 3, the first-conductivity-type semiconductor layer 4 made of AlGaInP, the active layer 5 (the multiple quantum well layer), the second-conductivity-type semiconductor layer 6 made of AlGaInP, and a patterned photoresist layer 8, and the substrate layer 1 is a sapphire substrate or a silicon substrate. The roughened layer 7 is disposed on the surface of the second-conductivity-type semiconductor layer 6, and part of the second-conductivity-type semiconductor layer 6 is exposed by a pattern of the patterned photoresist layer 8. The roughened layer 7 is formed by roughening the surface of the second-conductivity-type semiconductor layer 6.

In an exemplary implementation, the method for manufacturing a semiconductor device includes the following operations.

A red-yellow AlGaInP epitaxial wafer is provided, and the epitaxial wafer includes the GaP layer 3, the first-conductivity-type semiconductor layer 4, the active layer 5, the second-conductivity-type semiconductor layer 6, and a GaAs substrate (not shown) which are stacked. The red-yellow AlGaInP epitaxial wafer is bonded to a new substrate using bonding technology, and the new substrate is the substrate layer 1 shown in FIG. 5a. The substrate layer 1 is, for example, a sapphire substrate (Al₂O₃) or a Si substrate, and a Si substrate is typically adopted.

Laser lift-off is performed on the original GaAs substrate of the epitaxial wafer subjected to substrate transfer, thereby separating the original GaAs substrate from the second-conductivity-type semiconductor layer 6.

Then, a wet etching process is adopted to roughen the surface of the second-conductivity-type semiconductor layer 6 to form the roughened layer 7. Based on different roughening processes, a surface roughness range of the roughened layer 7 is typically 300 nm to 1200 nm (a surface roughness is represented by a roughening depth, for example; and a light emitting effect may be affected if the roughening depth is either too large or too small).

A photoresist mask layer 8 is formed on the semiconductor device subjected to surface roughening, and is subjected to photolithographic patterning for preparation for etching.

Then, step S1 is performed. That is, before step S1 is performed, the roughened layer 7 having a certain surface roughness range is obtained by roughening the surface of the second-conductivity-type semiconductor layer 6, and step S1 is performed to modify the roughened layer 7 having the certain surface roughness range, so as to reduce a surface roughness of the roughened layer 7.

At step S1, the roughened layer 7 is modified with the first process gas, so as to reduce the surface roughness of the roughened layer 7. In the first process gas, the chemical etching gas includes Cl₂, and the physical bombardment gas includes Ar, that is, a combination of Cl₂ and Ar is used as the first process gas.

In some embodiments, the proportion of the physical bombardment gas in the first process gas is greater than that of the chemical etching gas in the first process gas.

With the etching method provided in the present disclosure, the roughened layer is first modified with the first process gas including the chemical etching gas and the physical bombardment gas, that is, the surface roughness of the roughened layer is reduced under a chemical etching effect of the chemical etching gas and a physical bombardment effect of the physical bombardment gas. By setting the proportion of the physical bombardment gas in the first process gas to be greater than that of the chemical etching gas in the first process gas, on the one hand, ion bombardment is performed on the roughened surface of the roughened layer by use of physical bombardment characteristics of ions of the physical bombardment gas, thereby reducing the surface roughness; on the other hand, by simultaneously using a smaller amount of chemical etching gas, a bombardment effect can be adjusted, and chemical etching can be additionally performed on the roughened surface, thereby further reducing the surface roughness of the roughened layer, and achieving etching on debris generated by ion bombardment to reduce subsequent generation of protrusions on the etched surface. Thus, a loading influence caused by etching by-products of the roughened surface can be reduced, and the subsequent generation of the protrusions on the etching surface can also be reduced. In a subsequent process of continuously etching to the target depth with a second process gas, since an etching load of the surface of the roughened layer is reduced by the modification, smooth etching morphology can be obtained, which improves brightness and electrical stability of chips.

On this basis, in some embodiments, a gas flow ratio range of the physical bombardment gas (e.g., Ar) to the chemical etching gas (e.g., Cl₂) in the first process gas is 5:1 to 20:1. The gas flow ratio range is used for adjustment to the bombardment effect.

In some embodiments, a flow range of the physical bombardment gas (e.g., Ar) is 25 sccm to 200 sccm, and a flow range of the chemical etching gas (e.g., Cl₂) is 5 sccm to 40 sccm.

In some embodiments, a total gas flow range of the physical bombardment gas (e.g., Ar) and the chemical etching gas (e.g., Cl₂) is 30 sccm to 240 sccm.

In some embodiments, at step S1 of etching the roughened layer 7 with the first process gas, a pressure range of a process chamber is 2 mT to 8 mT.

In some embodiments, process parameters adopted at step S1 further include: an upper electrode RF power range: 300 W to 800 W; a lower electrode RF power range: 50 W to 300 W; a process temperature range: 120°C to 150°C; and a process time range: 10 s to 60 s.

Step S1 is a pretreatment step for a main etching step. In an exemplary implementation of step S1, the physical bombardment gas (e.g., Ar) and the chemical etching gas (e.g., Cl₂) are introduced into a process chamber of an Inductively Coupled Plasma (ICP) apparatus, and the gas flow ratio range of the physical bombardment gas (e.g., Ar) to the chemical etching gas (e.g., Cl₂) is 5:1 to 20:1, and is mainly used for adjustment to the bombardment effect. A certain chamber pressure is maintained, and the pressure in the process chamber is a fixed value selected from a range of 2 mT to 8 mT. A certain upper electrode RF power is applied to ionize the gases in the process chamber to generate plasma, and the upper electrode RF power range is 300 W to 800 W; and a certain lower electrode RF power is then applied to accelerate the plasma downwards to bombard the surface of the roughened layer 7 for etching, and the lower RF power range is 50 W to 300 W. A wafer (i.e., the semiconductor device) is placed on a quartz chiller or a SiC chiller, a backside gas (i.e., He) with a certain pressure is introduced below the chiller for cooling the chiller and improving temperature uniformity of the chiller, conductive heat dissipation is performed to control a surface temperature (i.e. a process temperature) of the wafer on the chiller to be above 120°C (e.g., 120°C to 150°C) and to avoid photoresist burning, the surface temperature of the wafer is determined by the RF power (including the upper electrode RF power and the lower electrode RF power) in the process recipe and the temperature control system (i.e., the chiller) together, and the surface temperature of the wafer is basically determined in a certain range after the RF power is selected according to a process recipe. The process time range is, for example, 10s to 60s, and is determined by a surface roughening thickness of the roughened layer 7 and an etching rate together.

The etching process at step S1 involves the following chemical equations:

Ar→Ar⁺+e;

Cl₂→Cl⁻+Cl*+e;

AlGaInP (bulk material)+Ar⁺+e→AlGaInP↑ (molecule)+Ar (physical bombardment);

AlGaInP+Cl⁻→GaCl3↑+AlCl₃↑+InCl₃↑+PCl_{y}↑ (y=3, 5) (chemical etching).

At step S1, a Cl₂+Ar gas system is adopted for etching of a region, which is not covered by the photoresist mask, of the surface of the roughened layer 7 made of AlGaInP, and other regions of the roughened surface of the roughened layer 7 are protected by the photoresist mask and thus are not damaged. At step S1, Ar⁺ ion bombardment is mainly performed on the region, which is not covered by the mask, of the roughened surface of the roughened layer 7 by use of suitable power conditions and the physical bombardment characteristics of Ar ions, thereby reducing the surface roughness. It can be easily understood that step S1 is performed to modify the roughened layer 7 having the certain surface roughness range, and on the premise that the roughened layer 7 has the certain surface roughness, bombarding the roughened surface of the roughened layer 7 with the Ar⁺ ions can reduce the surface roughness of the roughened layer 7. On the contrary, bombarding a smooth surface with the Ar⁺ ions may increase surface roughness.

Secondly, during the process, by using a small amount of Cl₂, on the one hand, the bombardment effect can be adjusted; on the other hand, a small amount of Cl radicals can also enhance the chemical etching on the roughened surface, thereby further reducing the surface roughness of the roughened layer 7. In particular, the Cl radicals can further etch part of the debris generated by the bombardment by the Ar⁺ ions, which can reduce the subsequent generation of the protrusions on the etched surface.

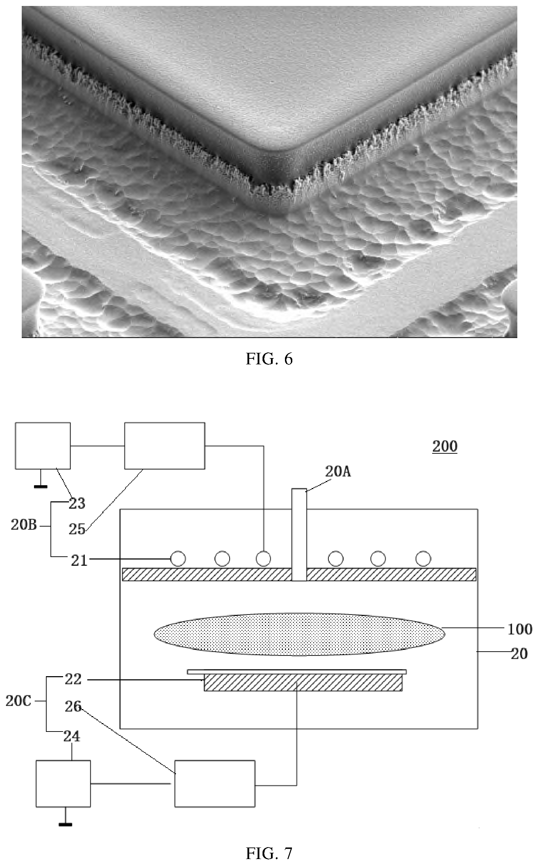

It should be noted that the physical bombardment by the Ar⁺ ions constitutes a main etching part, most of AlGaInP of the roughened surface of the roughened layer 7 is bombarded off by the Ar⁺ ions, but since the roughened surface of the roughened layer 7 is honeycombed (the roughened surface morphology as shown in FIG. 6) and has many voids, some of fine particles generated by the bombardment may be stuck at a bottom or a sidewall of the roughened surface, in which case the bombardment by the Ar⁺ ions cannot directly act, and only the chemical etching by the Cl radicals can work. As the etching proceeds, an etching temperature gradually rises, and a small number of by-products such as AlClₓ and InClₓ generated by the chemical etching gradually volatilize, which reduces generation of micro-masks in the subsequent etching process, and also reduces the subsequent generation of the protrusions on the etched surface.

For example, a process recipe of step S1 is as follows: Pressure (chamber Pressure) 2 mT-8 mT/SRF (upper electrode RF power) 300 W-800 W/BRF (lower electrode RF power) 50 W-300 W/25 sccm-200 sccm Ar+5 sccm-40 sccm Cl₂/4 Torr-8 Torr backside He/chiller (wafer carrier) temperature 0°C-70°C/process time 10 s-60 s (adjustable based on roughening depths). A film layer structure obtained after step S1 is completed is as shown in FIG. 5b.

At S2, the modified roughened layer 7, the second-conductivity-type semiconductor layer 6, the active layer 5, and the first-conductivity-type semiconductor layer 4 are etched with a second process gas to a target depth.

At step S2, the second process gas includes Cl₂, BCl₃, and HBr. In some embodiments, a gas flow ratio range of Cl₂, BCl₃, and HBr in the second process gas is 1:2:5 to 1:2:20.

In some embodiments, a flow range of Cl₂ is 5 sccm to 20 sccm, a flow range of BCl₃ is 20 sccm to 40 sccm, and a flow range of HBr is 25 sccm to 100 sccm.

In some embodiments, the upper electrode RF power range is 400 W to 900 W, and the lower electrode RF power range is 200 W to 450 W.

In some embodiments, the chamber pressure range is 2 mT to 6 mT.

In some embodiments, process parameters adopted at step S2 further include: the upper electrode RF power range: 400 W to 900 W; the lower electrode RF power range: 200 W to 450 W; the process temperature range: 120°C to 150°C; and the process time range: 300 s to 700 s.

Step S2 is the main etching step, and in an exemplary implementation, after the above first etching step (i.e., the pretreatment step) is completed, the main etching step is switched to directly to perform a second etching step. During the etching at step S2, since the surface roughness of the roughened layer 7 is optimized, a Cl₂+BCl₃+HBr gas system is adopted for etching based on requirements of smooth sidewall morphology, but due to the fact that the by-products of AlGaInP are hard to volatilize, an etching gas and RF power in a process recipe need to be controlled within a certain range, so as to avoid affecting an electrical result. Therefore, after step S1 is completed, Cl₂, BCl₃, and HBr are introduced into the process chamber, and the gas flow ratio (Cl₂: BCl₃: HBr) range of Cl₂, BCl₃, and HBr is 1:2:5 to 1:2:20. A certain chamber pressure is maintained, and the chamber pressure is a fixed value selected from a range of 2 mT to 6 mT. A certain upper electrode RF power is applied to ionize the gases in the process chamber to generate plasma, and the upper electrode RF power range is 400 W to 900 W; and a certain lower electrode RF power is then applied to accelerate the plasma downwards to bombard surfaces of materials for etching, and the lower RF power range is 200 W to 450 W. The wafer (i.e., the semiconductor device) is placed on the quartz chiller or the SiC chiller, the backside gas (i.e., He) with a certain pressure is introduced below the chiller for cooling the chiller and improving the temperature uniformity of the chiller, conductive heat dissipation is performed to control the surface temperature (i.e. the process temperature) of the wafer on the chiller to be above 120°C and to avoid photoresist burning. The process time range is, for example, 300s to 700s.

For example, a process recipe of step S2 is as follows: Pressure (chamber Pressure) 2 mT-6 mT/SRF (upper electrode RF power) 400 W-900 W/BRF (lower electrode RF power) 200 W-450 W/5 sccm-20 sccm Cl₂+20 sccm-40 sccm BCl₃+25 sccm-100 sccm HBr/4 Torr backside He/chiller temperature 0°C-70°C/process time 300 s-700 s (adjustable based on different etching depths or etching recipes). A film layer structure obtained after step S2 is completed is as shown in FIG. 5c.

An etching result obtained by etching according to a combination of the process recipes of steps S1 and S2 is as shown in FIG. 6. As can be seen, the etching morphology obtained by the method for manufacturing a semiconductor device provided in the present embodiment exhibits a smooth bottom and sidewall, so that the brightness and electrical stability of the chips are effectively improved.

It should be noted that the present embodiment just takes the roughened layer 7 made of AlGaInP for illustration, and the method provided in the present disclosure is also applicable to etching of a roughened layer containing In or Al. Accordingly, for the roughened layer 7 made of other different materials or the first-conductivity-type semiconductor layer 4, the active layer 5, and the second-conductivity-type semiconductor layer 6 which are made of other different materials, the first process gas and the second process gas may be selectively replaced with other corresponding gases based on requirements of the above etching effect of the present disclosure.

### Second Embodiment

FIG. 7 is a schematic structural diagram of a semiconductor process apparatus according to an embodiment of the present disclosure.

As shown in FIG. 7, the semiconductor process apparatus 200 includes a process chamber 20, a gas inlet assembly 20A, an upper electrode assembly 20B, a lower electrode assembly 20C, and a controller (not shown in FIG. 7). The controller includes at least one processor and at least one storage device, and the storage device has stored therein a computer program which, when executed by the processor, implements the method for manufacturing a semiconductor device according to any one of the above embodiments.

Illustratively, the controller may be an upper computer or a lower computer. The controller may control a valve in the gas inlet assembly 20A to be opened to introduce a corresponding process gas into the process chamber 20; and the controller may further control a degree of opening of the valve in the gas inlet assembly 20A to control a flow rate of the process gas. The controller may further control a pumping assembly to pump the process chamber 20, so as to control a pressure (i.e., a chamber pressure) in the process chamber 20 and discharge reaction by-products.

The upper electrode assembly 20B includes an RF coil 21, an upper RF power supply 23, and an upper matcher 25. The controller is further configured to control the upper RF power supply 23 to apply an upper electrode RF power to the RF coil 21 through the upper matcher 25, so as to enable the RF coil 21 to excite the process gas in the process chamber 20 to generate plasma 100.

The lower electrode assembly 20C includes a wafer carrier 22, a lower RF power supply 24, and a lower matcher 26. The controller is further configured to control the lower RF power supply 24 to apply a lower electrode RF power to a lower electrode of the wafer carrier 22 through the lower matcher 26, so that the lower electrode of the wafer carrier 22 may provide an RF bias to adsorb the plasma above an object to be etched (e.g., a wafer) to bombard the object to be etched.

The semiconductor process apparatus 200 in the embodiment of the present disclosure may be an ICP etching apparatus or a Capacitively Coupled Plasma (CCP) etching apparatus. A type of the semiconductor process apparatus 200 is not limited in the embodiment of the present disclosure.

The embodiments of the present disclosure are described above, but the above description is illustrative rather than exhaustive, and the present disclosure is not limited to the disclosed embodiments. Many modifications and changes are apparent to those of ordinary skill in the art without departing from the scope and spirit of the embodiments of the present disclosure.

## Claims

1. A method for manufacturing a semiconductor device, the semiconductor device comprising a first-conductivity-type semiconductor layer, an active layer, and a second-conductivity-type semiconductor layer which are stacked from bottom to top, a roughened layer being disposed on a surface of the second-conductivity-type semiconductor layer, and the method comprising:
modifying the roughened layer with a first process gas to reduce surface roughness of the roughened layer, the first process gas comprising a chemical etching gas capable of reacting with the roughened layer and a physical bombardment gas capable of physically bombarding the roughened layer, and a proportion of the physical bombardment gas in the first process gas being greater than a proportion of the chemical etching gas in the first process gas; and
etching the modified roughened layer, the second-conductivity-type semiconductor layer, the active layer, and the first-conductivity-type semiconductor layer to a target depth with a second process gas.

2. The method for manufacturing a semiconductor device of claim 1, wherein the roughened layer contains In and/or Al.

3. The method for manufacturing a semiconductor device of claim 2, wherein a material of the roughened layer comprises AlGaInP.

4. The method for manufacturing a semiconductor device of claim 1, wherein a gas flow ratio range of the physical bombardment gas to the chemical etching gas in the first process gas is 5:1 to 20:1; or
a flow range of the physical bombardment gas is 25 sccm to 200 sccm, and a flow range of the chemical etching gas is 5 sccm to 40 sccm; or
a total gas flow range of the physical bombardment gas and the chemical etching gas in the first process gas is 30 sccm to 240 sccm; or
at step of etching the roughened layer with the first process gas, a pressure range of a process chamber is 2 mT to 8 mT.

5. The method for manufacturing a semiconductor device of claim 4, wherein process parameters adopted at step of etching the roughened layer with the first process gas further comprise:
an upper electrode radio frequency power range: 300 W to 800 W;
a lower electrode radio frequency power range: 50 W to 300 W;
a process temperature range: 120°C to 150°C; and
a process time range: 10 s to 60 s.

6. The method for manufacturing a semiconductor device of any one of claims 1 to 5, wherein the chemical etching gas comprises Cl₂, and the physical bombardment gas comprises Ar.

7. The method for manufacturing a semiconductor device of claim 3, wherein the roughened layer, the first-conductivity-type semiconductor layer, and the second-conductivity-type semiconductor layer are made of the same material.

8. The method for manufacturing a semiconductor device of claim 7, wherein the second process gas comprises Cl₂, BCl₃, and HBr.

9. The method for manufacturing a semiconductor device of claim 8, wherein a gas flow ratio range of Cl₂, BCl₃, and HBr in the second process gas is 1:2:5 to 1:2:20; or
in the second process gas, a flow range of Cl₂ is 5 sccm to 20 sccm, a flow range of BCl₃ is 20 sccm to 40 sccm, and a flow range of HBr is 25 sccm to 100 sccm; or
a chamber pressure range is 2 mT to 6 mT; or
at step of continuously etching the roughened layer, the second-conductivity-type semiconductor layer, the active layer, and the first-conductivity-type semiconductor layer to the target depth with the second process gas, an upper electrode radio frequency power range is 400 W to 900 W, and a lower electrode radio frequency power range is 200 W to 450 W.

10. A semiconductor process apparatus, comprising a process chamber, a gas inlet assembly, an upper electrode assembly, a lower electrode assembly, and a controller, wherein the controller comprises at least one processor and at least one storage device having stored therein a computer program which, when executed by the at least one processor, implements the method for manufacturing a semiconductor device of any one of claims 1 to 9.
